# EUROPEAN PATENT SPECIFICATION

(11) **EP 3 435 637 B1**
(45) Date of publication and mention of the grant of the patent: **20.10.2021**
(21) Application number: 18185136.1
(22) Date of filing: 24.07.2018
(51) Int. Cl.: H04M 1/02, H04M 1/18, H01Q 1/24, H01Q 1/48, H01Q 9/42, H01Q 21/28

(54) **ELECTRONIC DEVICE AND METHOD OF MANUFACTURING HOUSING OF SAME**
ELEKTRONISCHE VORRICHTUNG UND VERFAHREN ZUR HERSTELLUNG EINES GEHÄUSES DAFÜR
DISPOSITIF ÉLECTRONIQUE ET PROCÉDÉ DE FABRICATION DE SON BOÎTIER

(30) Priority: 24.07.2017 KR 20170093809
(43) Date of publication of application: 30.01.2019
(73) Proprietor: Samsung Electronics Co., Ltd., Gyeonggi-do 16677 (KR)
(72) Inventor: Kim, Koang-Soo, 16677 Suwon-si (KR); Kang, Myung-Heon, 16677 Suwon-si (KR); Kim, Seong-Hyeon, 16677 Suwon-si (KR); Le, Young-Tae, 16677 Suwon-si (KR); Chung, Soon-Wan, 16677 Suwon-si (KR); Cheon, Eon-Seog, 16677 Suwon-si (KR)
(74) Representative: Nederlandsch Octrooibureau

(56) References cited:
- EP-A2- 0 641 643
- EP-A2- 3 118 714
- US-A1- 2016 116 948
- US-A1- 2016 352 007

## Description

### FIELD

Various embodiments disclosed herein relate to an electronic device, and more particularly, to an electronic device including a case and/or a housing made of a metallic material, and a method of manufacturing the housing of the electronic device.

### DESCRIPTION OF RELATED ART

Typically, an electronic device can perform a specific function according to a program incorporated therein or a selected specific function from a wide variety of functions, such as an electronic scheduler, a portable multimedia reproducer, a mobile communication terminal, a tablet PC, an image/sound device, a desktop/laptop PC, or a vehicular navigation system, including a home appliance. For example, the above-mentioned electronic devices may output information stored therein as sound or an image. As the integration degree of such electronic devices has increased, and superhigh speed and large-capacity wireless communication have become popular, more functions are being incorporated into single mobile communication terminals. For example, various functions, such as an entertainment function (e.g., a game function), a multimedia function (e.g., a music/video reproducing function), a communication and security function for mobile banking, a schedule management function, and an e-wallet function, are integrated in a single electronic device, in addition to a communication function.

The above information is presented as background information only to assist with an understanding of the present disclosure. No determination has been made, and no assertion is made, as to whether any of the above might be applicable as prior art with regard to the present disclosure.

US 2016/352007 A1 discloses a housing for use in e.g. a mobile phone including a metallic base defining a slit, a plurality of metallic members arranged in the slit at intervals, and a non-conductive member formed between each two neighbouring metallic members and between the metallic base and the metallic members adjacent to the metallic base. The plurality of the metallic pieces and the metallic base are connected by the non-conductive member.

EP 0 641 643 A2 discloses a casing 30 of a device, the casing comprising an aluminium sheet 10 on a bottom part and a plastic resin 12. An adhesive 14 is coated on the aluminium sheet before application of the resin to the metal sheet.

US 2016/116948 A1 discloses an electronic device 100 including a body 10, a housing 30 assembled to the body and an antenna 50 located inside the housing 30. The housing 30 can include a metal base 31 and a non-conductive member 33, a dielectric member 35 received in the metal base 31. Sections of a portion of the metal base 31 are cut off to form at least one gap 315. A dielectric member 35 is received in the gap 315.

EP 3 118 714 A2 discloses a computer housing, wherein an aluminium sheet forms a structural support layer. An adhesive layer 213 is applied over the support layer 212. A TPE material is moulded onto the adhesive layer 213 over structural support layer 212 structure to form the protective layer 214.

### SUMMARY

The invention is as set out in the independent claims 1 and 9, preferred forms being set out in dependent clams 2 to 8 and 10 to 13.

### BRIEF DESCRIPTION OF THE DRAWINGS

The above and other aspects, features, and advantages of the present disclosure will be more apparent from the following detailed description taken in conjunction with the accompanying drawings, in which:
FIG. 1 is a block diagram illustrating an electronic device within a network environment, according to various embodiments;
FIG. 2 is a block diagram illustrating a wireless communication module, a power management module, and an antenna module of an electronic device according to various embodiments;
FIG. 3 is an exploded perspective view illustrating an electronic device according to various embodiments;
FIG. 4 is a perspective view illustrating an electronic device according to various embodiments;
FIG. 5 is a cross-sectional view of the electronic device, which is taken along line A-A' of FIG. 4;
FIG. 6 is a cross-sectional view for describing an antenna structure of an electronic device according to various embodiments;
FIG. 7 is a flowchart for describing a method of manufacturing the housing of an electronic device according to various embodiments;
FIG. 8 is a perspective view illustrating a metallic member formed by an operation of forming a metallic member in a method according to various embodiments;
FIG. 9 is a perspective view illustrating a primary housing member manufactured through insert injection molding in the method according to various embodiments;
FIG. 10 is a perspective view illustrating a secondary housing member manufactured through a computer numerical control machining in the method according to various embodiments; and
FIG. 11 is a top plan view of the secondary housing member manufactured according to various embodiments, in which synthetic resin material portions are removed.

### DETAILED DESCRIPTION

In describing the drawings, similar reference numerals may be used to designate similar constituent elements. A singular expression may include a plural expression unless they are definitely different in a context. In the present disclosure, the expression "A or B", "at least one of A or/and B", or "one or more of A or/and B" may include all possible combinations of the items listed. The expression "a first", "a second", "the first", or "the second" used in various embodiments may modify various components regardless of the order and/or the importance but does not limit the corresponding components. When an element (e.g., first element) is referred to as being "(functionally or communicatively) connected," or "directly coupled" to another element (second element), the element may be connected directly to the another element or connected to the another element through yet another element (e.g., third element).

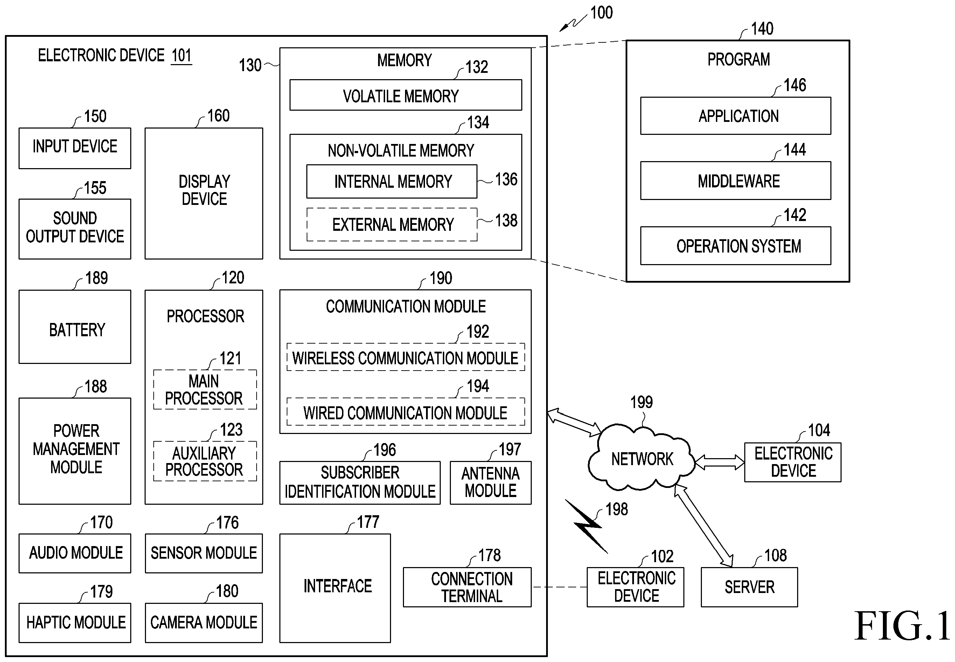

FIG. 1 is a block diagram illustrating an electronic device 101 in a network environment 100, according to various embodiments.

Referring to FIG. 1, the electronic device 101 in the network environment 100 may communicate with an electronic device 102 via a point-to-point connection 198 (e.g., short-range wireless communication, such as Bluetooth, Wi-Fi P2P, and NFC), or may communicate with an electronic device 104 or a server 108 via a second network 199 (e.g., long-range wireless communication). According to an embodiment, the electronic device 101 may communicate with the electronic device 104 via the server 108. According to one embodiment, the electronic device 101 may include a processor 120, a memory 130, an input device 150, a sound output device 155, a display device 160, an audio module 170, a sensor module 176, an interface 177, a haptic module 179, a camera module 180, a power management module 188, a battery 189, a communication module 190, a subscriber identification module 196, and an antenna module 197. In some embodiments, at least one (e.g., the display device 160 or the camera module 180) of these components may be eliminated from the electronic device 101 or other components may be added to the electronic device 101. In some embodiments, some components may be implemented in an integrated form like, for example, the sensor module 176 (e.g., a fingerprint sensor, an iris sensor, or an illuminance sensor), which is embedded in, for example, the display device 160 (e.g., a display).

The processor 120 may control one or more other components (e.g., a hardware or software component) of the electronic device 101, which are connected to the processor 120, and may perform various data processing and arithmetic operations by driving, for example, software (e.g., a program 140). The processor 120 may load commands or data, which are received from other components (e.g., the sensor module 176 or the communication module 190), into a volatile memory 132 so as to process the commands or data, and may store resulting data into a non-volatile memory 134. According to one embodiment, the processor 120 may include a main processor 121 (e.g., a central processing unit or an application processor) and an auxiliary processor 123 operated independently from the main processor 121. The auxiliary processor 123 may additionally or alternatively use a lower power than the main processor 121, or may include an auxiliary processor 123 specialized for a designated function (e.g., a graphic processor device, an image signal processor, a sensor hub processor, or a communication processor). Here, the auxiliary processor 123 may be operated separately from the main processor 121 or in the manner of being embedded with the main processor 121.

In this case, the auxiliary processor 123 may control at least some functions or states associated with at least one of the components of the electronic device 101 (e.g., the display device 160, the sensor module 176, or the communication module 190), on behalf of the main processor 121, for example, while the main processor 121 is in an inactive (e.g., sleep) state, or together with the main processor 121 while the main processor 121 is in an active (e.g., application execution) state. According to one embodiment, the auxiliary processor 123 (e.g., an image signal processor or a communication processor) may be implemented as some of other functionally related components (e.g., camera module 180 or communication module 190). The memory 130 may store various data used by at least one component (e.g., the processor 120 or the sensor module 176) of the electronic device 101, for example, software (e.g., the program 140) and input or output data, which is associated with commands associated the software. The memory 130 may include, for example, a volatile memory 132 or a non-volatile memory 134.

The program 140 may be software stored in the memory 130 and may include, for example, an operating system 142, middleware 144, or application 146.

The input device 150 is a device from the outside (e.g., the user) for receiving commands or data to be used in a component (e.g., the processor 120) of the electronic device 101, and may include, for example, a microphone, a mouse, or a keyboard.

The sound output device 155 is a device for outputting a sound signal to the outside of the electronic device 101. The output device 155 may include, for example, a speaker for general use such as multimedia reproduction or sound reproduction and a receiver used only for telephone reception. According to one embodiment, the receiver may be formed integrally with or separately from the speaker.

The display device 160 is a device for visually providing information to a user of the electronic device 101 and may include, for example, a display, a hologram device, or a projector and a control circuit for controlling the corresponding device. According to one embodiment, the display device 160 may include a touch circuit or a pressure sensor capable of measuring the intensity of the pressure on the touch.

The audio module 170 may bidirectionally convert sound and electrical signals. According to one embodiment, the audio module 170 may acquire sound through the input device 150 or may output sound through the sound output device 155 or an external electronic device (e.g., the electronic device 102 (e.g., a speaker or headphone)) connected with the electronic device 101 in a wireless or wired manner.

The sensor module 176 may generate an electrical signal or a data value corresponding to an internal operating state (e.g., power or temperature) of the electronic device 101 or an external environmental condition. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support a designated protocol that may be connected to an external electronic device (e.g., the electronic device 102) in a wired or wireless manner. According to one embodiment, the interface 177 may include a High Definition Multimedia Interface (HDMI), a Universal Serial Bus (USB) interface, an SD card interface, or an audio interface.

The connection terminal 178 may be a connector capable of physically interconnecting the electronic device 101 and an external electronic device (e.g., the electronic device 102), such as an HDMI connector, a USB connector, an SD card connector, or an audio connector (e.g., a headphone connector).

The haptic module 179 may convert an electrical signal into a mechanical stimulus (e.g., vibration or motion) or an electrical stimulus that the user can perceive through a tactile or kinesthetic sense. The haptic module 179 may include, for example, a motor, a piezoelectric element, or an electrical stimulation device.

The camera module 180 is a device that is capable of capturing, for example, a still image and a video image. According to one embodiment, the camera module 180 may include one or more lenses, an image sensor, an image signal processor, or a flash.

The power management module 188 is a module for managing power supplied to the electronic device 101, and may be configured as at least a part of, for example, a Power Management Integrated Circuit (PMIC).

The battery 189 is a device for supplying power to at least one component of the electronic device 101 and may include, for example, a non-rechargeable primary battery, a rechargeable secondary battery, or a fuel cell.

The communication module 190 may establish a wired or wireless communication channel between the electronic device 101 and an external electronic device (e.g., the electronic device 102, the electronic device 104, or the server 108) and may support communication via the established communication channel. The communication module 190 may include a processor 120 (e.g., an application processor) and one or more communication processors, which are independently operated and support wired communication or wireless communication. According to one embodiment, the communication module 190 may include a wireless communication module 192 (e.g., a cellular communication module, a short range wireless communication module, or a Global Navigation Satellite System (GNSS) communication module) or a wired communication module 194 (e.g., Local Area Network (LAN) communication module or a power line communication module), and may communicate with an external electronic device via a first network 198 (e.g., a short-range communication network, such as Bluetooth, WiFi direct, or Infrared Data Association (IrDA)) or a second network 199 (e.g., a long-range communication network, such as a cellular network, the Internet, or a computer network (e.g., LAN or WAN)), using a corresponding communication module among the above-mentioned communication modules. Various types of communication modules 190 described above may be implemented as a single chip in which at least some of the communication modules are integrated, or may be implemented as separate chips.

According to one embodiment, the wireless communication module 192 may identify and authenticate the electronic device 101 within the communication network using the user information stored in the subscriber identification module 196.

The antenna module 197 may include one or more antennas configured to transmit/receive signals or power to/from the outside. According to one embodiment, the communication module 190 (e.g., the wireless communication module 192) may transmit/receive signals to/from an external electronic device via an antenna suitable for the communication scheme thereof.

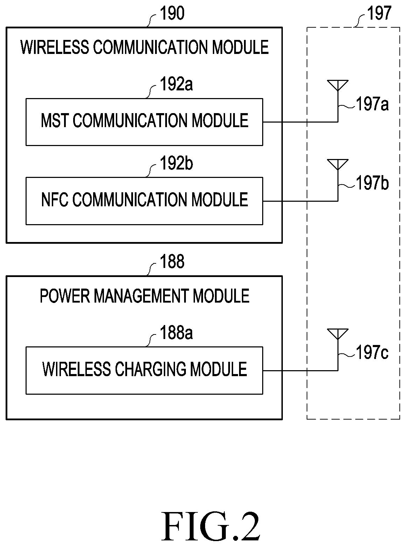

FIG. 2 is a block diagram illustrating a wireless communication module 192, a power management module 188, and an antenna module 197 of an electronic device according to various embodiments.

Further referring to FIG. 2, the wireless communication module 192 may include an magnetic secure transmission (MST) communication module 192a or an NFC communication module 192b, and the power management module 188 may include a wireless charging module 188a. In this case, the antenna module 197 may separately include a plurality of antennas, which includes an MST antenna 197a connected to the MST communication module 192a, an NFC antenna 197b connected to the NFC communication module 192b, and a wireless charging antenna 197c (or wireless inductor) connected to the wireless charging module 188a. In another embodiment, the wireless communication module 190 may include a cellular communication module, a GNSS communication module, a Bluetooth communication module, a WiFi module, an IrDA module, or the like. The antenna module 197 may also include additional antennas corresponding to the configuration of the wireless communication module 192 as described above. When the case and/or the housing of an electronic device (e.g., the electronic device 101 of FIG. 1) at least partly includes a metallic material, at least one of the antennas included in the antenna module 197 is formed to include a metallic material portion. For the convenience of description, components overlapping with those in FIG. 1 will not be described or will be described briefly.

The MST communication module 192a may receive a signal (e.g., a signal including control information or settlement information) from the processor 120, may generate a magnetic signal corresponding to the received signal via the MST antenna 197a, and may then transmit the generated magnetic signal to an external electronic device 102 (e.g., a POS device). According to one embodiment, for example, the MST communication module 192a may include a switching module (not illustrated), which includes one or more switches connected to the MST antenna 197a, and may change the direction of the voltage or current supplied to the MST antenna 197a by controlling the switching module. More specifically, it is possible to change the direction of a magnetic signal (e.g., magnetic field) that is sent via the MST antenna 197a and is transmitted to an external electronic device 102 via, for example, the first network 198. The magnetic signal, which is transmitted in the state in which the direction thereof is changed, may cause a form and effect similar to magnetic field that is generated when a magnetic card is swiped in a card reader of an electronic device 102. According to one embodiment, settlement-related information and control information, which are received in the form of magnetic signals by an electronic device 102, are transmitted to the settlement server (e.g., a server 108) via the second network 199, for example.

The NFC communication module 192b may acquire signals (e.g., the signal including the control information or settlement information) from the processor 120, and may transmit the acquired signal to an external electronic device 102 via the NFC antenna 197b. According to one embodiment, the NFC communication module 192b may receive signals (e.g., signals including the control information or settlement information) sent from an external electronic device 102 via the NFC antenna 197b.

The wireless charging module 188a may wirelessly transmit power to the external electronic device 102 (e.g., a mobile phone or a wearable device) via a wireless charging antenna 197c, or may wirelessly receive power from an external electronic device 102 (e.g., a wireless charging device). The wireless charging module 188a may support various wireless charging schemes including, for example, a magnetic resonance scheme or magnetic induction scheme.

According to one embodiment, some of the MST antenna 197a, the NFC antenna 197b, and the wireless charging antenna 197c may share at least a part of a radiation unit. For example, the radiation unit of the MST antenna 197a may be at least partially used as the radiation unit of the NFC antenna 197b or the wireless charging antenna 197c, and vice versa. When the MST antenna 197a, the NFC antenna 197b, and the wireless charging antenna 197c share at least a partial region of a radiation unit, the antenna module 197 may include a switching circuit (not illustrated) configured to selectively connect or disconnect (e.g., open) at least some of the antennas 197a, 197b, and 197c according to the control of the wireless communication module 192 (e.g., the MST communication module 192a or the NFC communication module 192b) or the power management module 188 (e.g., the wireless charging module 188a). For example, when the electronic device 101 uses the wireless charging function, the NFC communication module 192b or the wireless charging module 188a may temporally disconnect at least a partial region of the radiation unit, which is shared by the NFC antenna 197b and the wireless charging antenna 197c, from the NFC antenna 197b and may connect the partial region of the radiation unit only to the wireless charging antenna 197c by controlling the switching circuit.

According to one embodiment, at least some functions of the MST communication module 192a, the NFC communication module 192b, and the wireless charging module 188a may be controlled by an external processor (e.g., the processor 120). According to one embodiment, the designated functions (e.g., settlement functions) of the MST communication module 192a or the NFC communication module 192b may be performed in a Trusted Execution Environment (TEE). The TEE according to various embodiments may be an execution environment in which at least some designated regions in the memory 130 are allocated in order to carry out, for example, functions that require a relatively high level of security (e.g., financial transaction or personal information-related functions) and access to the designated regions is distinguished and limitedly allowed depending on, for example, an access subject or an application to be executed.

Some of the above components may be connected to each other via a communication scheme (e.g., a bus, a General-Purpose Input/Output (GPIO), a Serial Peripheral Interface (SPI), or a Mobile Industry Processor Interface (MIPI) and may exchange signals (e.g., commands or data) therebetween.

According to one embodiment, the commands or data may be transmitted or received between the electronic device 101 and the external electronic device 104 via the server 108 connected to the second network 199. Each of the electronic devices 102 and 104 may be of a type, which is the same as or different from the electronic device 101. According to one embodiment, all or some of the operations executed in the electronic device 101 may be executed in another external electronic device or a plurality of external electronic devices. According to one embodiment, in the case where the electronic device 101 should perform a certain function or service automatically or by a request, the electronic device 101 may request some functions, which are associated with the function or service, from an external electronic device, instead of, or in addition to, executing the functions or the service by itself. The external electronic device, which receives the request, may execute the requested functions or additional functions, and may transmit the results to the electronic device 101. The electronic device 101 may provide the requested functions or services by processing the received results as they are or additionally. For this purpose, for example, a cloud computing technique, a distributed computing technique, or a client-server computing technique may be used.

The electronic device according to various embodiments disclosed herein may be various types of devices. The electronic device may, for example, include at least one of a portable communication device (e.g., smartphone) a computer device, a portable multimedia device, a portable medical device, a camera, a wearable device, and a home appliance. The electronic device according to one embodiment is not limited to the above described devices.

The term "module" as used herein may include a unit consisting of hardware, or hardware programmed with software or firmware, or a combination thereof, and may, for example, be used interchangeably with the term "logic", "logical block", "component", "circuit", or the like. The "module" may be an integrated component, or a minimum unit for performing one or more functions or a part thereof. For example, the module may be implemented by an application-specific integrated circuit (ASIC).

Various embodiments as described herein may be implemented by memory storing software (e.g., program 140) such as instructions stored in machine-readable storage media (e.g., internal memory 136 or external memory 138). The machine is a device that calls the stored instruction from the storage media and can operate according to the called instruction, and may include an electronic device (e.g., electronic device 101) according to the disclosed embodiments. The instruction(s), when executed by a processor (e.g., processor 120), may cause the processor to directly execute a function corresponding to the instruction or cause other elements to execute the function under the control of the processor. The instruction(s) may include code that is generated or executed by a compiler or interpreter. The machine-readable storage media may be provided in the form of non-transitory storage media. Here, the term "non-transitory" only means that the storage media is tangible without including a signal, irrespective of whether data is semi-permanently or temporarily stored in the storage media.

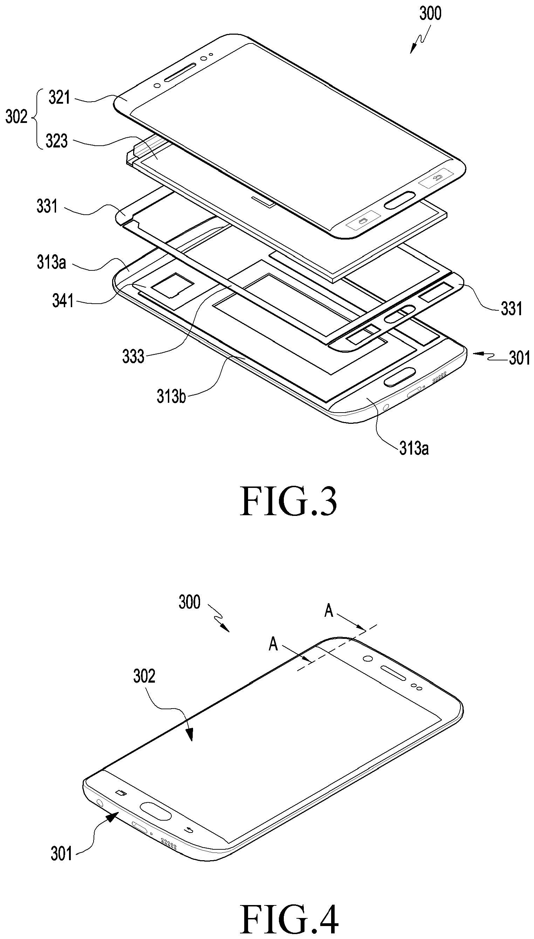

FIG. 3 is a perspective illustrating an electronic device 300 according to various embodiments in a disassembled state. FIG. 4 is a perspective illustrating an electronic device 300 according to various embodiments.

Referring to FIGS. 3 to 4, the electronic device 300 (e.g., the electronic device 101, 102, or 104 in FIG. 1) may include a housing 301 and a display device 302 mounted on one face of the housing 301. The housing 301 may accommodate a circuit board 341, a battery (e.g., the battery 189 in FIG. 1), and the like therein, and the display device 302 may be mounted on the open side (e.g., front face) of the housing 301 so as to complete the appearance of the electronic device 300. According to various embodiments, at least some of the components of the electronic device 101 of FIG. 1 described above may be mounted on the circuit board 341. For example, the processor 120, the memory 130, the audio module 170, the power management module 188, the communication module 190, etc. in FIG. 1 may be manufactured in the form of integrated circuit chips and may be mounted on the circuit board 341.

According to one embodiment, the display device 302 may be joined to the front face of the housing 301 via one or more adhesive members 331 and 333. For example, the adhesive members 331 and 333 may include a piece of double-sided tape for joining the display device 302 to the housing 301, and a waterproof function may be provided between the housing 301 and the display device 302.

According to various embodiments, the housing 301 may include at least one first attachment surface 313a and at least one second attachment surface 313b formed on the front face. The first attachment surface 313a may be formed on, for example, each of the opposite end portions (e.g., the upper and lower end portions) of the housing 301 in the length direction of the housing 301. According to one embodiment, the first attachment surface 313a may extend in the width direction of the housing 301. The second attachment surface 313b may be formed on, for example, each of the opposite end portions (e.g., opposite lateral end portions) of the housing 301 in the width direction of the housing 301. The "length direction" shall refer to the dimension that is longer, while the "width dimension" shall refer to the dimension that is shorter. According to one embodiment, the second attachment surface 313b may extend in the longitudinal direction of the housing 301. In some embodiments, the first attachment surfaces 313a and the second attachment surfaces 313b may be alternately arranged on the front face of the housing 301 while extending along, for example, edges such that the first attachment surfaces 313a and the second attachment surfaces 313b may form a closed curve (or polygonal) shape.

According to various embodiments, the display device 302 may include a window member 321 and a display panel 323 integrated with the window member 321. The window member 321 may be disposed on the front face of the housing 301 and may substantially form the appearance of the electronic device 300 together with the housing 301. The window member 321 may be made of a transparent material (e.g., a transparent synthetic resin or glass) so as to protect the display panel 323 from the external environment while transmitting a screen output from the display panel 323. For example, the window member 321 may be mounted on the housing 301 in the state in which the display panel 323 is coupled to the inner face of the window member 321, and the display panel 323 may be accommodated within a space defined by the housing 301 and the window member 321.

In one embodiment, each of the adhesive members 331 and 333 may bond the window member 321 to a part of the housing 301 along an edge of the housing 301. For example, in the state in which the display panel 323 is coupled to the window member 321, the edge portions of the window member 321 may be attached to the first attachment surfaces 313a and/or the second attachment surfaces 313b of the housing 301. In some embodiments, at least some of the adhesive members 331 and 333 may attach a part of the display panel 323, other than the edge portions of the window member 321, to the housing 301. The positions, shapes, thicknesses, etc. of the adhesive members 331 and 333 may be designed in various ways depending on the shape of the housing 301 (e.g., the shapes or positions of the first attachment surfaces 313a and/or the second attachment surfaces 313b), the relative size between the window member 321 and the display panel 323, etc. The adhesive members 331 and 14 333 described above may provide a waterproof structure between the housing 301 and the display device 302 by being disposed in a substantially closed curve shape along the edges of the front face of the housing 301.

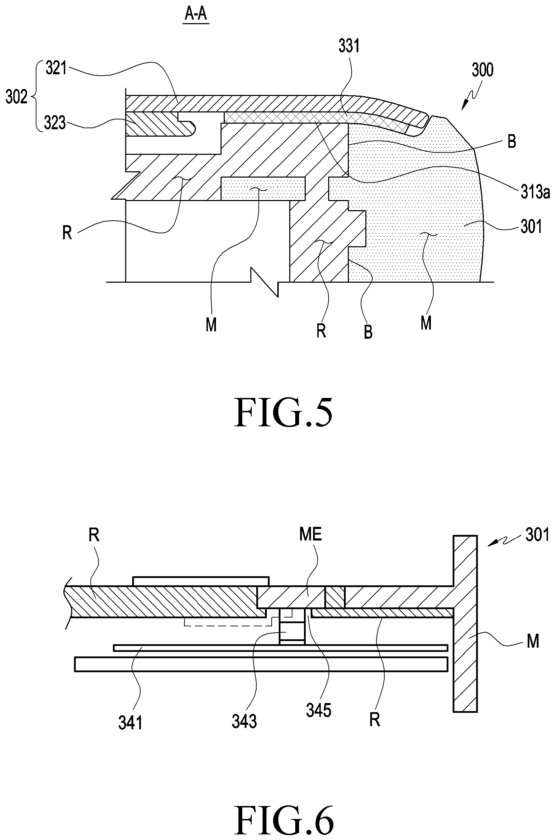

FIG. 5 is a cross-sectional view of the electronic device 300, which is taken along line A-A' of FIG. 4.

Referring to FIG. 5, the window member 321 of the display device 302 can be joined to the first attachment surface 313a at the upper face and/or the lower end of the housing 301 via the adhesive member 331. In some embodiments, when the upper face of the display panel 323 (e.g., the right end in FIG. 5) is placed substantially parallel with the upper end of the window member 321, the adhesive member 331 may attach a part of the display panel 323 to the first attachment surface 313a.

The housing 301 comprises a plurality of metallic material portions M and a synthetic resin material portion(s) R. The synthetic resin material portion R can comprise a sealing resin and is joined and insert injection molded to at least a part of the metallic material portion M. As a result of the insert injection molding, the synthetic resin material portion R may fill and assumes a shape of a cavity formed in the housing and the metallic material portion M. The sealing resin is disposed at the joint B between the metallic material portion M and the synthetic resin material portion R. The sealing resin is formed only in a part of the joint B, rather than in the entire joint portion B. For example, as will be described with reference to the manufacturing method to be described below, depending on a gap between the metallic material portion M and the synthetic resin material portion R in the bending portion B, the viscosity of a material for forming the sealing resin (e.g., adhesive), or the like, the sealing resin may be formed on a part of or the entirety of the joint B. The sealing resin may have a shape corresponding to the cured shape of the synthetic resin material portion R constituting the joint B. However, it is noted that since it is practically difficult to visually recognize the sealing resin by the naked eye, the sealing resin is omitted without being denoted by a reference numeral.

The sealing resin reinforces the joint force or joint structure between the metallic material portion M and the synthetic resin material portion R in the joint B. The sealing resin is disposed at the joint B to prevent infiltration of water and moisture, so that the waterproof performance can be improved. In some embodiments, depending on the use environment (temperature/humidity change, external load, impact, etc.) of the electronic device 300, cracks or the like may occur due to relative shrinkage/expansion of different kinds of materials (e.g., the metallic material portion M and the synthetic resin material portion R) or impact or load concentration. The sealing resin maintains the joint force substantially uniformly in the entirety of the joint B, so that stresses or the like occurring due to relative contraction/expansion can be dispersed, thereby preventing cracks or the like in the joint B. For example, the sealing resin can improve the waterproof performance, durability, reliability, and the like of the electronic device 300.

FIG. 6 is a cross-sectional view for describing an antenna structure of an electronic device (e.g., the electronic device 300 of FIG. 3) according to various embodiments.

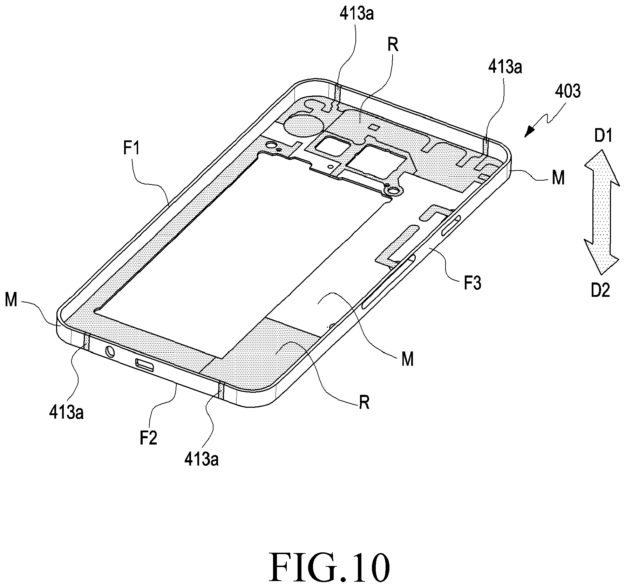

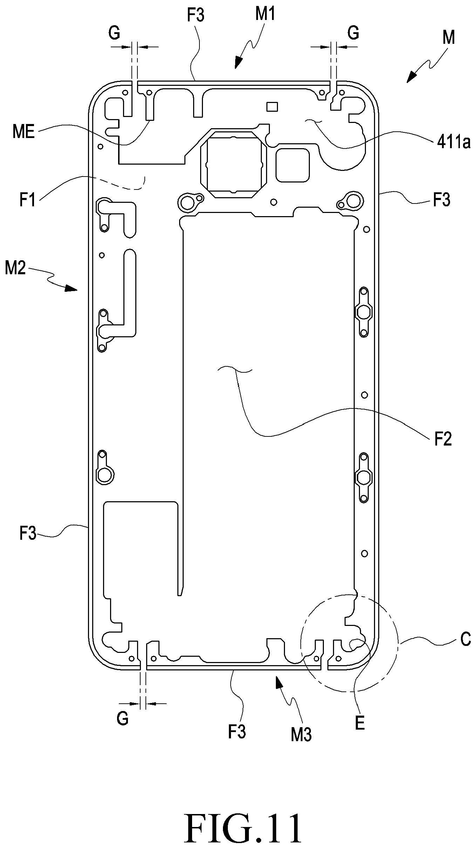

Referring to FIG. 6, the electronic device 300 may include an antenna device (e.g., the antenna module 197 of FIG. 1), which is formed of a part of the metallic material portion M of the housing 301. For example, the metallic material portion M may form at least a part of a side wall of the housing 301, and a part of the metallic material portion, which forms the side wall of the housing 301, may be electrically connected with a communication module (e.g., the wireless communication module 192 of FIG. 1) of the electronic device 300 so as to transmit and receive radio waves. In the metallic material portion M, the portions, which actually transmit and receive radio waves, may be mechanically connected to each other through the synthetic resin material portion R while being electrically insulated from the other portions in the metallic material portion M. The electrical insulation structure and/or the mechanical connection structure of the metallic material portion(s) M will be described in more detail with reference to FIG. 10 or 11.

According to various embodiments, in the metallic material portion M, the portions, which transmits and receives radio waves, may be electrically connected to the circuit board 341 (e.g., the circuit board on which the wireless communication module 192 is mounted) via the connection terminal 343 or the like. For example, the metallic material portion M may include an extension ME extending to the inside of the housing 301, and at least a part of the extension ME may be disposed to face the circuit board 341 through an opening 345 formed in the synthetic resin material portion R. The connection terminal 343 may include, for example, a C-clip mounted on the circuit board 341 and may be in contact with the extension ME above the opening 345. For example, at least a part of the metallic material portion M may be connected to the wireless communication module 192 via the connection terminal 343 so as to transmit and receive radio waves. According to one embodiment, a plurality of different portions in the metallic material portion M may be electrically isolated from each other while each of the different portions may be connected to the wireless communication module 192. For example, a plurality of different portions in the metallic material portion M may perform wireless communication in different frequency bands by being respectively connected to a cellular communication module, a global navigation satellite system (GNSS) communication module, a Bluetooth communication module, a WiFi module, etc.

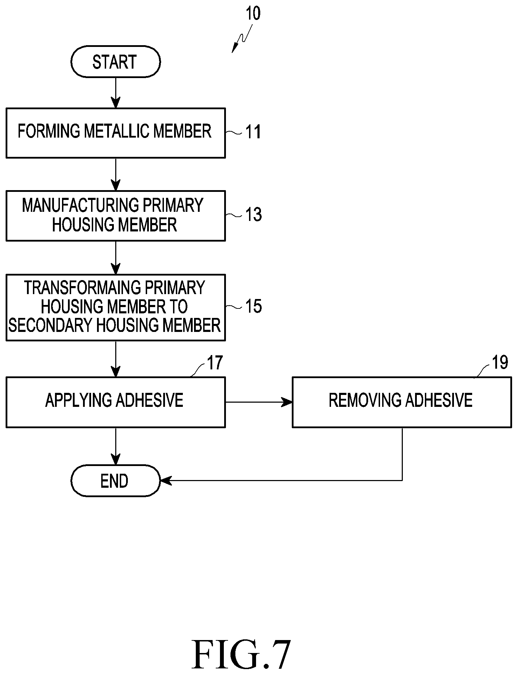

Hereinafter, a method of manufacturing a housing (e.g., the housing 301 of FIG. 3) of an electronic device according to various embodiments will be described with reference to FIGS. 7 to 11. In the following detailed description, reference may be made to the detailed description of the preceding embodiments or reference numerals in the drawings. Some of the components may be given the same reference numerals or the reference numerals thereof may be omitted, and the detailed description thereof may also be omitted.

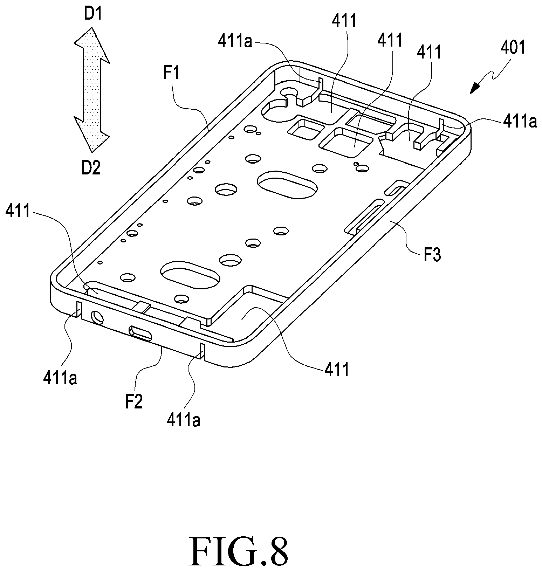

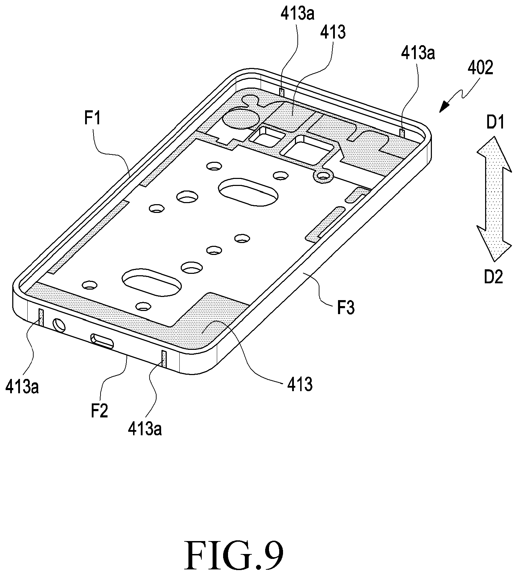

FIG. 7 is a flowchart for describing a method (10) for manufacturing a housing of an electronic device (e.g., the electronic device 101 or 300 in FIG. 1 or FIG. 3) according to various embodiments. FIG. 8 is a perspective view illustrating a metallic member 401 formed by an operation of forming a metallic member in the manufacturing method (10) according to various embodiments. FIG. 9 is a perspective view illustrating a primary housing member 402 manufactured through insert injection molding in the manufacturing method according to various embodiments. FIG. 10 is a perspective view illustrating a secondary housing member 403 manufactured through a computer numerical control machining in the method according to various embodiments. FIG. 11 is a top plan view of the secondary housing member 403 manufactured according to various embodiments, in which synthetic resin material portions R are removed.

Referring to Fig 7, a method (10) for manufacturing a housing of an electronic device according to various embodiments may include forming a metallic member (11), manufacturing a primary housing member (13), transforming the primary housing member to a secondary housing member (15), and applying an adhesive (17), and may further include removing a part of the adhesive (19) as needed.

The forming of the metallic member (11) may include manufacturing and machining through die casting, press working, or the like a metallic member corresponding to a rough shape of the housing to be manufactured. Further referring to FIG. 8, the metallic member 401 may be manufactured to have a shape having a space for accommodating other components (e.g., the circuit board 341 of FIG. 3) of the electronic device through processes such as die casting and press working, and may then be machined to include an opening 411 for arranging electric/electronic components such as a camera module, various sensors, and various sockets, holes for coupling/fastening with other components, etc. through a computer numerical control machining process. Thereafter, the metallic member 401 is manufactured into a housing (e.g., the housing 301 of FIG. 3) to be applied to an actual product through additional machining or the like.

According to one embodiment, the metallic member 401 may include a first face F1 facing a first direction D1, a second face F2 facing a second direction D2 opposite to the first direction D1, and a side wall F3 formed to at least partially enclose a space between the first face F1 and the second face F2. In some embodiments, the first face F1 may include a partially opened area. According to another embodiment, in the computer numerical control machining process, the metallic member 401 may include one or more cutouts 411a formed to cross a part of the side wall F3. A part of the metallic material is removed from the metallic member 401 in the course of further machining the metallic member 401 and the cutouts 411a may separate a part of the metallic portion (e.g., the part indicated by "M1" in FIG. 11), which is formed of another part of the metallic material 401, from another part of the metallic material portion (e.g., the part indicated by "M2" in FIG. 11).

Manufacturing the primary housing member (13) insert injection molding a synthetic resin member through insert injection molding and joining the synthetic resin member to the metallic member 401. The synthetic resin member may be joined to some of the openings 411 or a part of the surface of the metallic member 401. Referring to FIG. 9 again, the synthetic resin member 413 is molded in the state of filled in the cutouts 411a as well, and may be joined to the inner walls of the cutouts 411a. Hereinafter, the portion of the synthetic resin member 413, which is filled in each cutout 411a will be referred to as an "insulating portion 413a." The insulating portion 413a may be exposed to the outer surface of the metallic member 401, for example, the outside of the side wall F3.

Transforming the primary housing member into the secondary housing member (15) comprises removing a part of the primary housing member 402 through computer numerical control machining and includes an operation of machining the primary housing member 402 into a housing having a final shape to be practically applied and assembled to a final product. In the manufacturing of the secondary housing member (15), a part of each of the metallic member 401 and the synthetic resin member 413, which constitute the primary housing member 402, is removed, and the metallic material portion and the synthetic resin material portion (e.g., the metallic material portion M and the synthetic resin material portion R in FIG. 5) of the above-mentioned housing (e.g., the housing 301 in FIG. 3) may be completed. Referring to FIGS. 10 and 11 again, when a part of the primary housing member 402 is removed through the computer numerical control machining, the metallic material portion M are separated into first metallic portions M1 and M3 and a second metallic portion M2 by the cutouts 411a. Although it is described that "the first metallic material portions M1 and M3 and the second metallic portion M2 are separated from each other" in the detailed descriptions of embodiments, the first metallic material portions M1 and M3 and the second metallic material portion M2 are practically mechanically coupled to each other and electrically insulated from each other via the synthetic resin material portion R (e.g., the insulating portion 413a). In some embodiments, the first metallic material portions M1 and M3 may be formed at the upper and lower ends of the secondary housing member 403 and/or the metallic material portion M, respectively.

According to various embodiments, the first metallic material portions M1 and M3 may form the side wall F3 of the secondary housing member 403 and/or a part of the above-described housing (e.g., the housing 301 of FIG. 3), and the second metallic material portion M2 may form the second housing member 403 and/or another part of the above-described side wall F3 of the housing and/or a part of the second face F2. In some embodiments, the first metallic material portions M1 and M3 may also form a part of the second face F2. In another embodiment, the first metallic material portions M1, M3 may include an extension projecting inward of the secondary housing member 403, e.g., an extension ME of Figure 6, and the extension ME may be connected to the communication module via a connection terminal (e.g., the connection terminal 343 in FIG. 6) or the like. The first metallic material portions M1 and M3 operate as an antenna module (or a radiation conductor of the antenna module) that transmits and receives radio waves.

According to various embodiments, at least one end portion of each of the first metallic material portions M1 and M3 may be disposed adjacent to the second metallic material portion M2 with a predetermined gap G therebetween. The gaps G may be formed by the cutouts 411a, which are practically formed in a metallic member (e.g., the metallic member 401 in FIG. 8). In some embodiments, at least a part of the synthetic resin material portions R, for example, the insulating portions 413a, connects the first metallic material portions M1 and M3 and the second metallic material portion M2 to each other. For example, the first metallic material portions M1 and M3 may be maintained in the state of being mechanically coupled to the second metallic material portion M2 by the insulating portion 413a and electrically insulated from the second metallic material portion M2.

According to various embodiments, the shape of a part of the metallic member 401 or the metallic material portion M may include a somewhat complicatedly bent portion or a narrow space in a part of the synthetic resin member 413 or the region in which the synthetic resin material portion R is formed. For example, in a region indicated by "C" in FIG. 11, the inner edge E of the metallic material portion M may be a portion that is joined to the synthetic resin material portion R and may form a space in the form of a narrow recess. In the insert injection molding process, for example, in the primary housing member 402 manufacturing process, the metallic material portion M and the synthetic resin material portion R may be joined to each other in a joint portion (e.g., the joint portion B in FIG. 5) with a sufficient strength by controlling the viscosity of the molten resin, the molding temperature, and the injection pressure and speed of the molten resin.

In the manufacturing method according to various embodiments, by applying an adhesive along the bending portion between the metallic member M and the synthetic resin material portion R in one face (e.g., the inner face) of the secondary housing member 403, the joint strength of the joint portion can be further improved and the waterproof performance can be improved.

As described above, the applying of the adhesive (17) may be performed on one face of the secondary housing member 403. In the applying of the adhesive (17), the secondary housing member 403 may be transported in one direction by a transport device (e.g., a conveyor belt) in the state of being mounted on, for example, a jig. A dispensing unit is disposed on a path through which the secondary housing member 403 is conveyed, and the dispensing device applies an adhesive along the joint portion between the metallic material portion M and the synthetic resin material portion R. The adhesive dispensed through the dispensing unit may include cyanoacrylate and may have low viscosity.

According to various embodiments, when the adhesive applied to the secondary housing member 403 has sufficiently low viscosity (e.g., viscosity of 2 or less), the adhesive penetrates into the gap between the metallic material portion M and the synthetic resin material portion R in the joint portion (e.g., the joint portion B in FIG. 5) so as to be cured in the gap, thereby forming a sealing resin. The sealing resin reinforces the joint force between the metallic material portion M and the synthetic resin material portion R, and improves the waterproof and dustproof performance in the joint portion.

According to various embodiments, the manufacturing method 10 may further include removing a part of the adhesive (19). The adhesive may be applied to one face of the secondary housing member 403 and may generally penetrate into the gap between the metallic material portion M and the synthetic resin material portion R, but a part of the adhesive may be cured on the surface of the secondary housing member 403. In some embodiments, the secondary housing member 403 may be assembled with other components, and the adhesive cured on the surface of the secondary housing member 403 may interfere with other parts during such an assembly process, which may cause poor assembly. For example, in FIG. 5, the joint portion B is exposed to the first attachment surface 313a, and when the adhesive is applied and cured on the first attachment surface 313a, the adhesive force of the adhesive member 331 may deteriorate, and the housing 301 and the window member 321 may be out of outer surface alignment therebetween. In one embodiment, the removing of a part of the adhesive (19) is an operation of removing the adhesive which is cured on the surface of the secondary housing member without penetrating into the gap between the metallic material portion M and the synthetic resin material portion R, and the cured adhesive may be removed by polishing only the cured adhesive, or by dissolving the cured adhesive on the surface of the secondary housing member 403 using a solvent and then performing washing or the like. For example, the removing of a part of the adhesive (19) may smoothen the surface of the secondary housing member 403, so that the assembly quality of the secondary housing member 403 with the other components (e.g., the adhesive member 331 and/or the window member 321 of FIG. 5) can be improved.

While the present disclosure has been shown and described with reference to certain embodiments thereof, it will be understood by those skilled in the art that various changes in form and details may be made therein without departing from the scope of the present disclosure as defined by the appended claims.

## Claims

1. An electronic device comprising:
a housing (301), said housing comprising: a plurality of metallic material portions (M, M1, M2, M3) formed from at least one metallic member, said metallic portions (M, M1, M2, M3) disposed on an outer side of a side wall (F3) of the housing, and separated from each other by a gap (G, 411a); and
a synthetic resin material portion (R, 413a), the synthetic resin joined and injection molded to at least a part of the at least one metallic material portion (M, M1, M2, M3) to fill the gap (G, 411a); and
wherein a sealing resin is further disposed between an inner joint portion (B) of the metallic material portions (M, M1, M2, M3) and the synthetic resin material portion (R) and
the plurality of metallic material portions are mechanically connected to each other through the synthetic resin material portion (R) and at least one of the plurality of metallic material portions is configured to form an antenna module (197).

2. The electronic device of claim 1, wherein the housing (301) further comprises:
a first face (F1) that faces a first direction (D1),
a second face (F2) that faces a second direction (D2) opposite to the first direction, and
wherein the side wall (F3) is formed to at least partially enclose a space between the first face and the second face

3. The electronic device of claim 2, wherein the metallic material portions comprise:
a first metallic material portion (M1) , and a second metallic material portion (M2) that forms the part of the side wall (F3), wherein the second metallic material (M2) portion forms a part of the second face (F2), and
wherein at least a part of the synthetic resin material portion (R) is formed to connect the first metallic material portion (M1) and the second metallic material portion (M2) to each other.

4. The electronic device of claim 3, wherein the sealing resin material portion (R) is disposed at at least a portion of joint (B) between the first metallic material portion (M1) and the synthetic resin material portion or a joint (B) between the second metallic material portion (M2) and the synthetic resin material portion (R).

5. The electronic device of claim 3, wherein at least one end of the first metallic material portion (M1) is disposed adjacent to the second metallic material portion (M2) with a predetermined gap therebetween.

6. The electronic device of any one of claims 3 to 5, further comprising:
a communication module that is disposed in the housing,
wherein the communication module is configured to transmit and receive wireless signals through the first metallic material portion.

7. The electronic device of claim 1, further comprising:
an adhesive member attached to a joint (B) between the metallic material portion (M, M1,M2, M3) and the synthetic resin material portion (R) on the face (F1) of the housing (301).

8. The electronic device of claim 1, wherein the sealing resin (R) is cured at the joint (B) between the metallic material portion(M, M1, M2, M3) and the synthetic resin material portion (R).

9. A method for manufacturing a housing of an electronic device, the method comprising the steps of:
forming (11) a metallic member (M, 401);
manufacturing (13) a primary housing member (402) by insert injection molding to join a synthetic resin member (R, 413) to the metallic member (M, 401);
transforming (15) the primary housing member (402) into the secondary housing member (403) by removing a part of the primary housing member (402) through computer numerical control machining, dividing the metallic member into at least two metallic material portions (M1, M2, M3) and filling a cut-out portion (G, 411a) between the at least two metallic material portions (M1, M2) with at least a part of the synthetic resin member (R, 413a), after the part of the primary housing member is removed;
applying (17) an adhesive along an inner joint (B) between the metallic member (M) and the synthetic resin member (R), and
curing the adhesive in a gap between the metallic member (M) and the synthetic resin member (R) in at least a part of the joint, thereby forming a sealing resin,
wherein at least one of the at least two of metallic material portions is configured to form an antenna module (197).

10. The method of claim 9, wherein the forming of the metallic material (M) comprises the step of diecasting, computer numerical control machining, or pressing the metallic material (M).

11. The method of claim 9, wherein the adhesive has viscosity of 2 or less.

12. The method of claim 9, wherein the adhesive includes a cyanoacrylate component.

13. The method of claim 9, further comprising the step of:
removing (19) the adhesive cured on the surface of the secondary housing member after the adhesive is cured.

## Patentansprüche

1. Elektronische Vorrichtung, welche Folgendes umfasst:
ein Gehäuse (301), wobei das besagte Gehäuse Folgendes umfasst: eine Vielzahl von metallischen Materialteilen (M, M1, M2, M3), die aus mindestens einem metallischen Element gebildet sind, wobei die besagten metallischen Teile (M, M1, M2, M3) an einer Außenseite einer Seitenwand (F3) des Gehäuses angeordnet sind und durch eine Lücke (G, 411a) voneinander getrennt sind; und
einen Kunstharzmaterialteil (R, 413a), wobei das Kunstharz mit mindestens einem Teil des mindestens einen metallischen Materialteils (M, M1, M2, M3) verbunden und spritzgegossen ist, um die Lücke (G, 411a) zu füllen; und
wobei ferner ein Dichtungsharz zwischen einem inneren Verbindungsteil (B) der metallischen Materialteile (M, M1, M2, M3) und dem Kunstharzmaterialteil (R) angeordnet ist und
die Vielzahl von metallischen Materialteilen durch den Kunstharzmaterialteil (R) mechanisch miteinander verbunden sind und mindestens einer der Vielzahl von metallischen Materialteilen konfiguriert ist, um ein Antennenmodul (197) zu bilden.

2. Elektronische Vorrichtung nach Anspruch 1, wobei das Gehäuse (301) ferner Folgendes umfasst:
eine erste Seite (F1), die einer ersten Richtung (D1) zugewandt ist,
eine zweite Seite (F2), die einer zweiten Richtung (D2) entgegengesetzt zu der ersten Richtung zugewandt ist, und
wobei die Seitenwand (F3) so gebildet ist, dass sie zumindest teilweise einen Raum zwischen der ersten Seite und der zweiten Seite umschließt.

3. Elektronische Vorrichtung nach Anspruch 2, wobei die metallischen Materialteile Folgendes umfassen:
einen ersten metallischen Materialteil (M1) und einen zweiten metallischen Materialteil (M2), der den Teil der Seitenwand (F3) bildet, wobei der zweite metallische Material(M2)-Teil einen Teil der zweiten Seite (F2) bildet, und
wobei mindestens ein Teil des Kunstharzmaterialteils (R) gebildet ist, um den ersten metallischen Materialteil (M1) und den zweiten metallischen Materialteil (M2) miteinander zu verbinden.

4. Elektronische Vorrichtung nach Anspruch 3, wobei der abdichtende Harzmaterialteil (R) an mindestens einem Teil der Verbindung (B) zwischen dem ersten metallischen Materialteil (M1) und dem Kunstharzmaterialteil oder einer Verbindung (B) zwischen dem zweiten metallischen Materialteil (M2) und dem Kunstharzmaterialteil (R) angeordnet ist.

5. Elektronische Vorrichtung nach Anspruch 3, wobei mindestens ein Ende des ersten metallischen Materialteils (M1) angrenzend an den zweiten metallischen Materialteil (M2) mit einer vorbestimmten Lücke dazwischen angeordnet ist.

6. Elektronische Vorrichtung nach einem der Ansprüche 3 bis 5, welche ferner Folgendes umfasst:
ein Kommunikationsmodul, das in dem Gehäuse angeordnet ist,
wobei das Kommunikationsmodul konfiguriert ist, um drahtlose Signale durch den ersten metallischen Materialteil zu übertragen und zu empfangen.

7. Elektronische Vorrichtung nach Anspruch 1, welche ferner Folgendes umfasst:
ein Klebeelement, das an einer Verbindung (B) zwischen dem metallischen Materialteil (M, M1,M2, M3) und dem Kunstharzmaterialteil (R) auf der Seite (F1) des Gehäuses (301) angebracht ist.

8. Elektronische Vorrichtung nach Anspruch 1, wobei das abdichtende Harz (R) an der Verbindung (B) zwischen dem metallischen Materialteil (M, M1, M2, M3) und dem Kunstharzmaterialteil (R) ausgehärtet wird.

9. Verfahren zum Herstellen eines Gehäuses einer elektronischen Vorrichtung, wobei das Verfahren die folgenden Schritte umfasst:
Bilden (11) eines metallischen Elements (M, 401);
Herstellen (13) eines primären Gehäuseelements (402) durch Einsatzspritzgießen, um ein Kunstharzelement (R, 413) mit dem metallischen Element (M, 401) zu verbinden;
Transformieren (15) des primären Gehäuseelements (402) in das sekundäre Gehäuseelement (403) durch Entfernen eines Teils des primären Gehäuseelements (402) durch Bearbeiten mit computernumerischer Steuerung, Teilen des metallischen Elements in mindestens zwei metallische Materialteile (M1, M2, M3) und Füllen eines ausgeschnittenen Teils (G, 411a) zwischen den mindestens zwei metallischen Materialteilen (M1, M2) mit mindestens einem Teil des Kunstharzelements (R, 413a), nachdem der Teil des primären Gehäuseelements entfernt wurde;
Anwenden (17) eines Klebers entlang einer inneren Verbindung (B) zwischen dem metallischen Element (M) und dem Kunstharzelement (R), und
Aushärten des Klebers in einer Lücke zwischen dem metallischen Element (M) und dem Kunstharzelement (R) in mindestens einem Teil der Verbindung, wodurch ein Dichtungsharz gebildet wird,
wobei mindestens einer der mindestens zwei metallischen Materialteile konfiguriert ist, um ein Antennenmodul (197) zu bilden.

10. Verfahren nach Anspruch 9, wobei das Bilden des metallischen Materials (M) den Schritt des Druckgießens, des Bearbeitens mit computernumerischer Steuerung oder des Pressens des metallischen Materials (M) umfasst.

11. Verfahren nach Anspruch 9, wobei der Kleber eine Viskosität von 2 oder weniger hat.

12. Verfahren nach Anspruch 9, wobei der Kleber eine Cyanacrylatkomponente enthält.

13. Verfahren nach Anspruch 9, welches ferner den folgenden Schritt umfasst:
Entfernen (19) des auf der Oberfläche des sekundären Gehäuseelements ausgehärteten Klebers, nachdem der Kleber ausgehärtet ist.

## Revendications

1. Dispositif électronique comprenant :
un boîtier (301), ledit boîtier comprenant : une pluralité de parties de matériau métallique (M, M1, M2, M3) formées à partir d'au moins un élément métallique, lesdites parties métalliques (M, M1, M2, M3) disposées sur un côté extérieur d'une paroi latérale (F3) du boîtier, et séparées les unes des autres par un interstice (G, 411a) ; et
une partie de matériau de résine synthétique (R, 413a), la résine synthétique étant jointe et moulée par injection à au moins une part de l'au moins une partie de matériau métallique (M, M1, M2, M3) pour remplir l'interstice (G, 411a) ; et
où une résine d'étanchéité est en outre disposée entre une partie de joint (B) intérieur des parties de matériau métallique (M, M1, M2, M3) et la partie de matériau de résine synthétique (R) et
la pluralité de parties de matériau métallique sont reliées mécaniquement les unes aux autres à travers la partie de matériau de résine synthétique (R) et au moins l'une de la pluralité de parties de matériau métallique est configurée pour former un module d'antenne (197).

2. Dispositif électronique selon la revendication 1, où le boîtier (301) comprend en outre :
une première face (F1) qui fait face à une première direction (D1),
une deuxième face (F2) qui fait face à une deuxième direction (D2) opposée à la première direction, et
où la paroi latérale (F3) est formée de manière à entourer au moins partiellement un espace entre la première face et la deuxième face.

3. Dispositif électronique selon la revendication 2, où les parties de matériau métallique comprennent :
une première partie de matériau métallique (M1) et une deuxième partie de matériau métallique (M2) qui forme la part de la paroi latérale (F3), où la deuxième partie de matériau métallique (M2) forme une part de la deuxième face (F2), et
où au moins une part de la partie de matériau de résine synthétique (R) est formée pour relier la première partie de matériau métallique (M1) et la deuxième partie de matériau métallique (M2) l'une à l'autre.

4. Dispositif électronique selon la revendication 3, où la partie de matériau de résine d'étanchéité (R) est disposée au niveau d'au moins une partie de joint (B) entre la première partie de matériau métallique (M1) et la partie de matériau de résine synthétique ou un joint (B) entre la deuxième partie de matériau métallique (M2) et la partie de matériau de résine synthétique (R).

5. Dispositif électronique selon la revendication 3, où au moins une extrémité de la première partie de matériau métallique (M1) est disposée adjacente à la deuxième partie de matériau métallique (M2) avec un interstice prédéterminé entre elles.

6. Dispositif électronique selon l'une quelconque des revendications 3 à 5, comprenant en outre :
un module de communication qui est disposé dans le boîtier,
où le module de communication est configuré pour transmettre et recevoir des signaux sans fil à travers la première partie de matériau métallique.

7. Dispositif électronique selon la revendication 1, comprenant en outre :
un élément adhésif attaché à un joint (B) entre la partie de matériau métallique (M, M1, M2, M3) et la partie de matériau de résine synthétique (R) sur la face (F1) du boîtier (301).

8. Dispositif électronique selon la revendication 1, où la résine d'étanchéité (R) est traitée au niveau du joint (B) entre la partie de matériau métallique (M, M1, M2, M3) et la partie de matériau de résine synthétique (R).

9. Procédé de fabrication d'un boîtier d'un dispositif électronique, le procédé comprenant les étapes consistant à :
former (11) un élément métallique (M, 401) ;
fabriquer (13) un élément de boîtier primaire (402) par moulage par injection d'insert pour joindre un élément de résine synthétique (R, 413) à l'élément métallique (M, 401) ;
transformer (15) l'élément de boîtier primaire (402) en élément de boîtier secondaire (403) en retirant une partie de l'élément de boîtier primaire (402) par usinage à commande numérique par ordinateur, diviser l'élément métallique en au moins deux parties de matériau métallique (M1, M2, M3) et remplir une partie découpée (G, 411a) entre les au moins deux parties de matériau métallique (M1, M2) avec au moins une part de l'élément de résine synthétique (R, 413a), après que la part de l'élément de boîtier primaire est retirée ;
appliquer (17) un adhésif le long d'un joint intérieur (B) entre l'élément métallique (M) et l'élément de résine synthétique (R), et
traiter l'adhésif dans un interstice entre l'élément métallique (M) et l'élément de résine synthétique (R) dans au moins une part du joint, formant ainsi une résine d'étanchéité,
où au moins l'une des au moins deux des parties de matériau métallique est configurée pour former un module d'antenne (197).

10. Procédé selon la revendication 9, où la mise en forme du matériau métallique (M) comprend l'étape de moulage métallique, d'usinage à commande numérique par ordinateur ou de pressage du matériau métallique (M).

11. Procédé selon la revendication 9, où l'adhésif a une viscosité de 2 ou inférieure.

12. Procédé selon la revendication 9, où l'adhésif comprend un composant de cyanoacrylate.

13. Procédé selon la revendication 9, comprenant en outre l'étape consistant à :
retirer (19) l'adhésif traité sur la surface de l'élément de boîtier secondaire après que l'adhésif est traité.
